(19) Europäisches Patentamt / European Patent Office / Office européen des brevets

(11) **EP 2 109 138 B1**

(12) **EUROPEAN PATENT SPECIFICATION**

(45) Date of publication and mention of the grant of the patent:
**23.12.2015 Bulletin 2015/52**

(21) Application number: **07860238.0**

(22) Date of filing: **26.12.2007**

(51) Int Cl.:
*H01L 23/36* (2006.01)     *H01L 23/12* (2006.01)
*H01L 23/373* (2006.01)    *H01L 23/498* (2006.01)
*H01L 23/538* (2006.01)    *H01L 25/07* (2006.01)
*H01L 23/367* (2006.01)

(86) International application number:
**PCT/JP2007/075009**

(87) International publication number:
**WO 2008/078788 (03.07.2008 Gazette 2008/27)**

(54) **HEAT DISSIPATING SUBSTRATE AND ELECTRONIC DEVICE USING THE SAME**

WÄRMEABFÜHRENDES SUBSTRAT UND ELEKTRONISCHE ANORDNUNG DAMIT

SUBSTRAT DE DISSIPATION DE CHALEUR ET DISPOSITIF ELECTRONIQUE UTILISANT UN TEL SUBSTRAT

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **26.12.2006 JP 2006348935**

(43) Date of publication of application:
**14.10.2009 Bulletin 2009/42**

(73) Proprietor: **Kyocera Corporation**
**Kyoto-shi**
**Kyoto 612-8501 (JP)**

(72) Inventors:
• **ABE, Yuichi**
**Kirishima-shi**
**Kagoshima 899-4396 (JP)**
• **NAKAMURA, Kiyotaka**
**Kirishima-shi**
**Kagoshima 899-4396 (JP)**

(74) Representative: **Viering, Jentschura & Partner mbB**
**Patent- und Rechtsanwälte**
**Grillparzerstrasse 14**
**81675 München (DE)**

(56) References cited:
EP-A2- 1 107 310     EP-A2- 1 465 251
EP-A2- 1 523 037     DE-A1- 19 859 119
JP-A- 10 189 845     JP-A- 11 265 976
JP-A- 11 307 696     JP-A- S63 104 360
JP-A- 2003 017 627    JP-A- 2006 140 402
US-A- 5 172 301

**Description**

The present invention relates to a heat dissipating board on which is mounted a semiconductor device such as a IGBT (Insulated Gate Bipolar Transistor) element as well as an electronic component such as a dye-sublimation type thermal printer heat element and a thermal ink jet printer head element. A heat dissipating board as described in the preamble portion of patent claim 1 is known from EP 1 107 310 A2.

There have been known heat dissipating boards designed for use in an electronic apparatus such as a power transistor module and a switching power supply module. A typical heat dissipating board is constructed by bonding a copper plate acting as a circuit member onto a first main surface of a ceramic substrate and also bonding, onto a second main surface thereof opposite from the first main surface, a copper plate acting as a heat dissipating member that exhibits excellent heat dissipation capability. There may be a case where the copper plate is bonded to the ceramic substrate, with an active metal layer interposed there between. Moreover, there may be a case where the copper plate acting as a heat dissipating member is formed with a heat sink for achieving further diffusion of heat.

Such a technique is disclosed, for example, in JP 9-69590 A, or JP 2006-245437 A. EP 1 107 310 A2 discloses a heat dissipating board comprising: a ceramic substrate, a metal layer disposed on a surface of the ceramic substrate, and at least one heat dissipating member having a first surface which is brought into contact with the metal layer and a second surface located on an opposite side of the first surface, an area of the metal layer being larger than an area of the first surface but being smaller than an area of the second surface.

It is the object of the present invention to provide a heat dissipating board which is resistant to warpage and cracking even under repeated application and dissipation of heat.

This object is accomplished with a heat dissipating board as claimed in claim 1. Dependent claims are directed on features of preferred embodiments of the invention.

According to the invention, the heat dissipating member is so constituted that its metal layer-sided surface, which is the surface A, is made smaller in area than the heat dissipating member-sided surface of the metal layer, which is the surface B. That is, a space is present between the heat dissipating member and the metal layer. Even if application of heat and dissipation of heat are repeated in the heat dissipating board, by virtue of the presence of the space and the deformation of the heat dissipating member in itself, an induced thermal stress can be dispersed efficiently. As a result, it is possible to reduce a residual stress resulting from a difference in thermal expansion coefficient between the heat dissipating member and the ceramic substrate, and thereby reduce the occurrence of cracking in the ceramic substrate. Moreover, the surface A' of the heat dissipating member, which is located on an opposite side of the surface A, is larger in area than the surface B. Therefore, in a case where the heat dissipating board is so designed that the circuit member is disposed on the side of the ceramic substrate opposite from the side thereof on which is disposed the heat dissipating member, the heat produced in a circuit member-side region can be diffused easily toward the surface A'.

Moreover, according to the invention, since an electronic component is mounted on the heat dissipating board, it follows that accumulation of heat in the electronic component can be suppressed. It is thus possible to provide an electronic apparatus, such as a power module, having high-level heat dissipation characteristics.

Brief description of the drawings

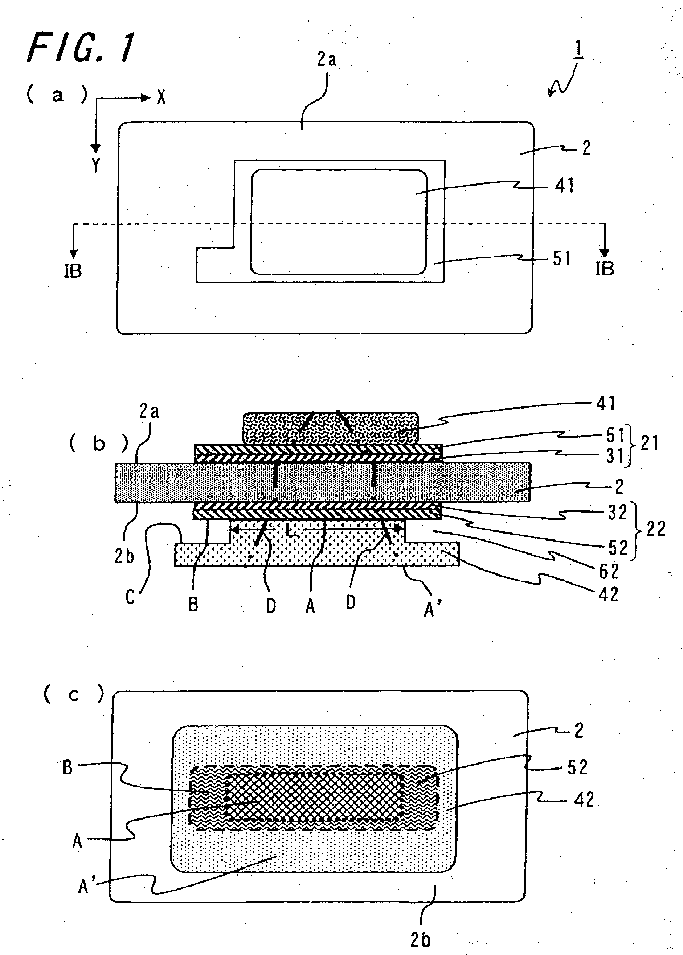

Fig. 1 is a diagram showing a heat dissipating board in accordance with an embodiment of the invention, wherein Fig. 1(a) is a plan view of the heat dissipating board as seen from a circuit member, Fig. 1(b) is a sectional view taken along the line IB-IB depicted in Fig. 1(a), and Fig. 1(c) is a bottom view of the heat dissipating board as seen from a heat dissipating member.

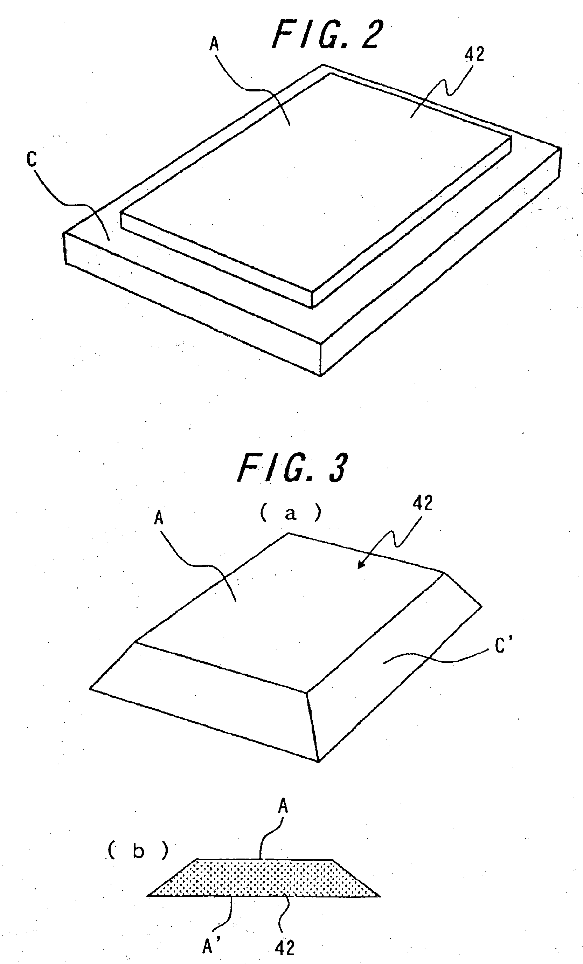

Fig. 2 is a perspective view showing the heat dissipating member adopted in Fig. 1.
Fig. 3 is a diagram showing a heat dissipating member of another type for use in the heat dissipating board in accordance with the embodiment, wherein Fig. 3(a) is a perspective view, and Fig. 3(b) is a sectional view.

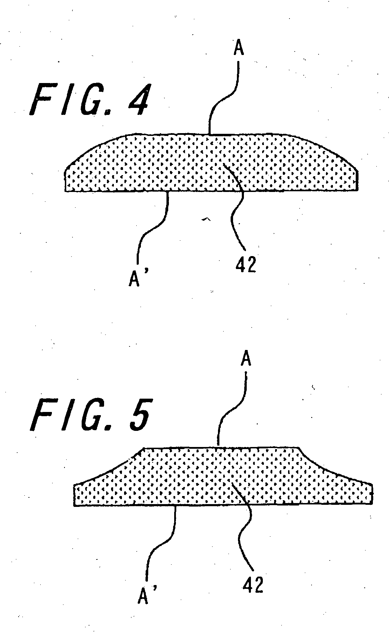

Fig. 4 is a sectional view showing still another heat dissipating member for use in the heat dissipating board in accordance with the embodiment.
Fig. 5 is a sectional view showing still another heat dissipating member of more type for use in the heat dissipating board in accordance with the embodiment.

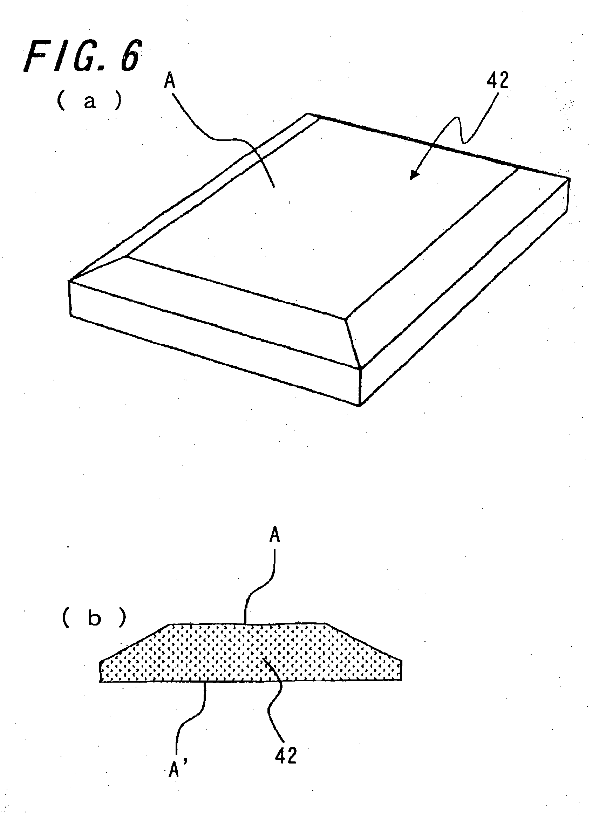

Fig. 6 is a diagram showing still another heat dissipating member for use in the heat dissipating board in accordance with the embodiment, wherein Fig. 6(a) is a perspective view, and Fig. 6(b) is a sectional view.

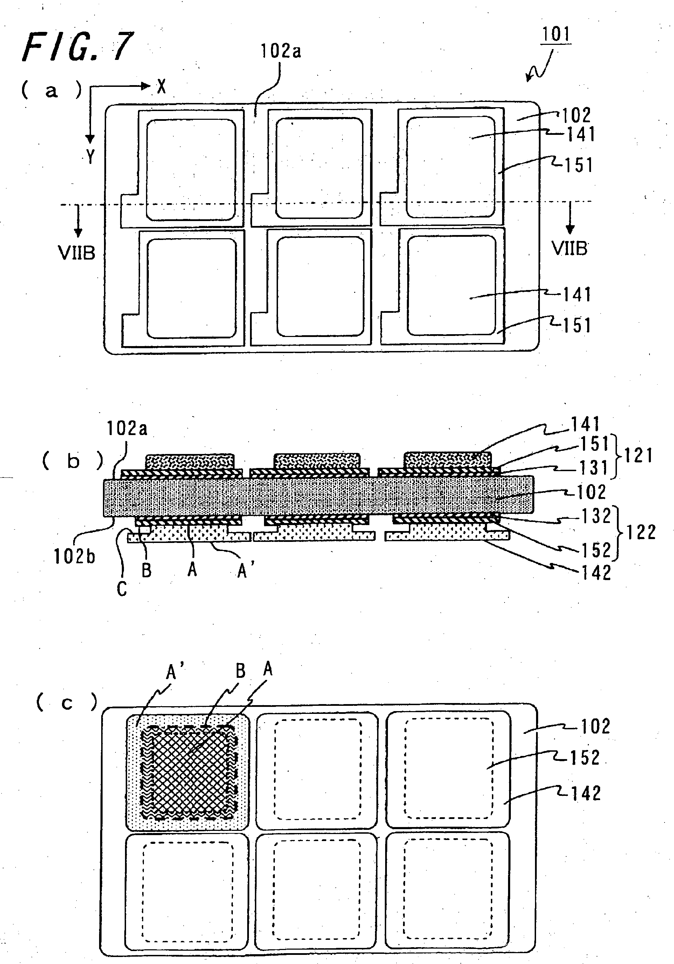

Fig. 7 is a diagram showing a heat dissipating board in accordance with another embodiment of the invention, wherein Fig. 7(a) is a plan view of the heat dissipating board as seen from the circuit member, Fig. 7(b) is a sectional view taken along the line VIIB-VIIB depicted in Fig. 7(a), and Fig. 7(c) is a bottom view of the heat dissipating board as seen from the heat dissipating member.

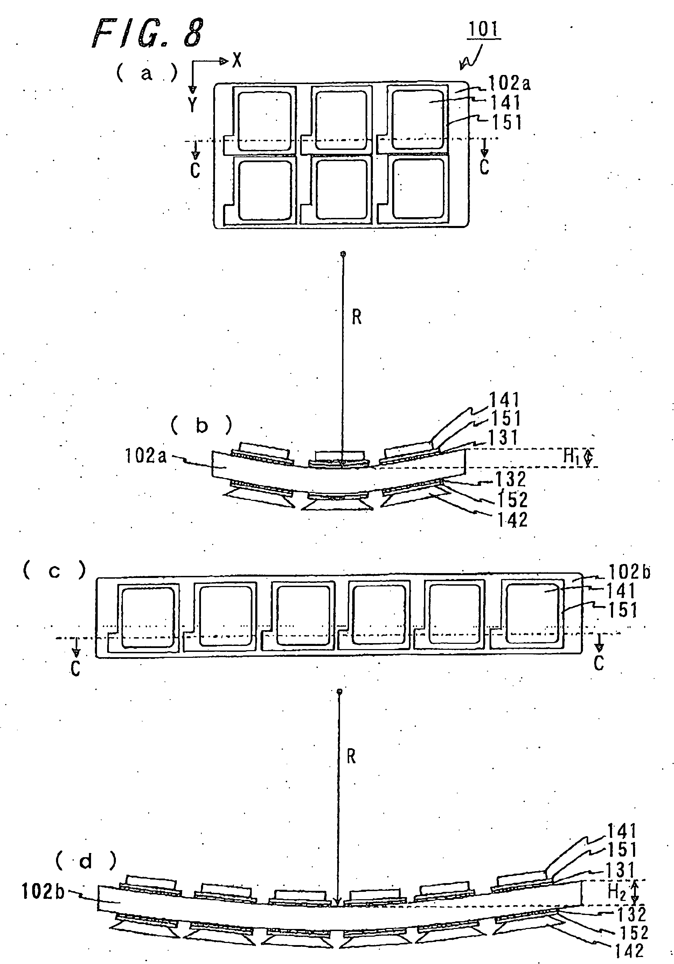

Fig. 8 is a diagram explaining the warpage of the heat dissipating board, wherein Fig. 8(b) is a sectional view showing schematically the warpage occurring along the line C-C depicted in Fig. 8(a) of the heat dissipating board arranged in the form of a matrix consisting of a plurality of rows and a plurality of columns, and Fig. 8(d) is a sectional view showing schematically the warpage occurring along the line C-C depicted in Fig. 8(c) of the heat dissipating board arranged in the form of a matrix consisting of one row and a plurality of columns.

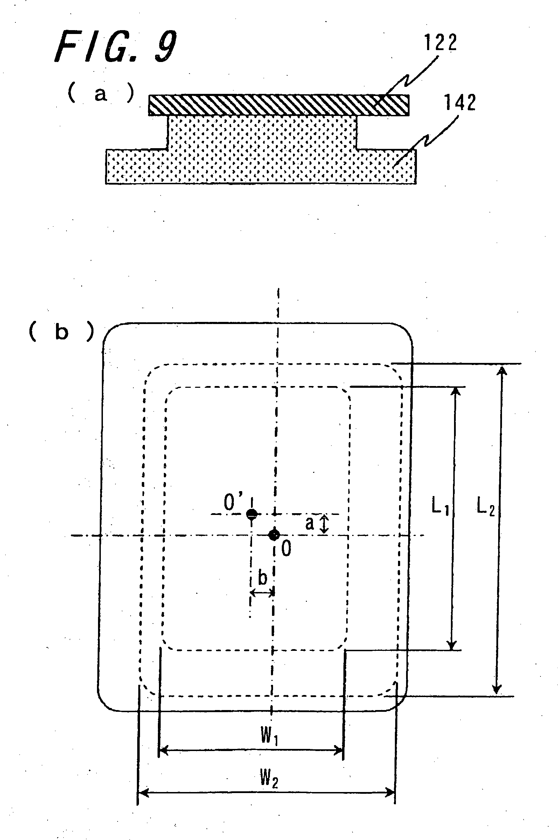

Fig. 9 is a diagram for explaining a relationship in arrangement between the metal layer and the heat dissipating member of the heat dissipating board, wherein Fig. 9(a) is a fragmentary sectional view of the heat dissipating board, and Fig. 9(b) is a bottom view of the heat dissipating board as seen from the heat dissipating member.

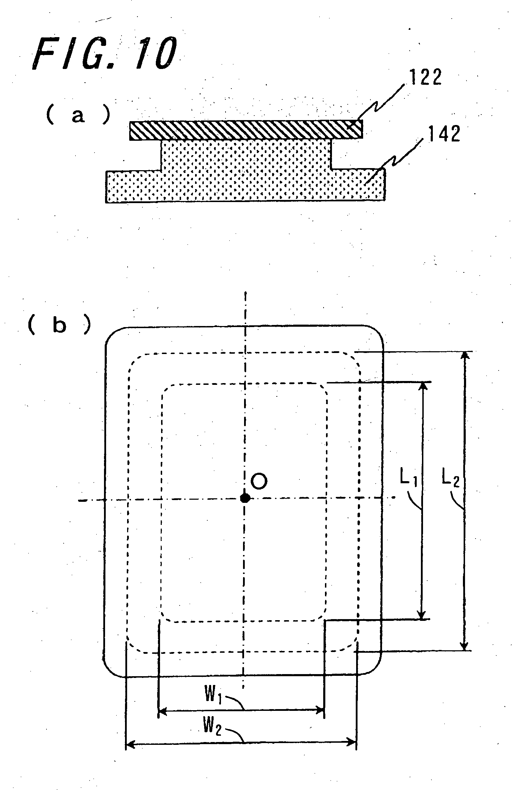

Fig. 10 is a diagram showing a case where the center of the metal layer and the center of the heat dissipating member of the heat dissipating board coincide with each other in Fig. 9, wherein Fig. 10(a) is a fragmentary sectional view of the heat dissipating board, and Fig. 10(b) is a bottom view of the heat dissipating board as seen from the heat dissipating member.

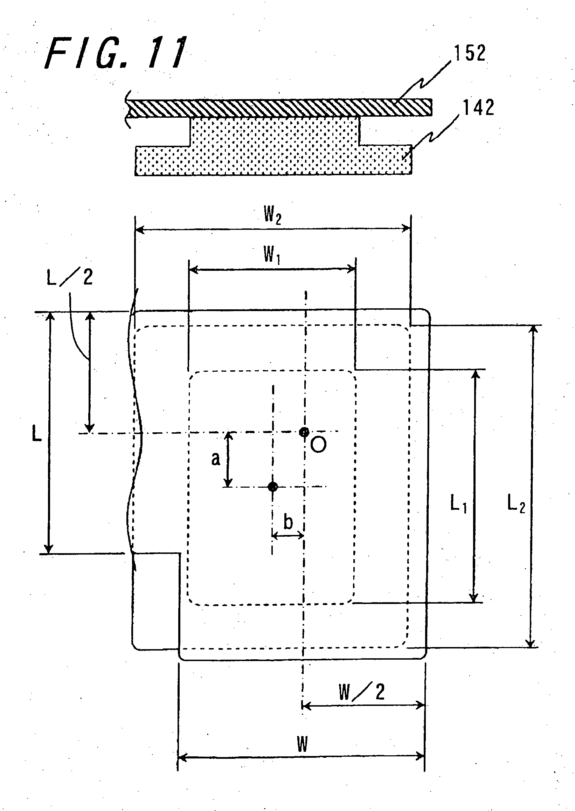

Fig. 11 is a diagram showing a case where the center of the metal layer and the center of the heat dissipating member of the heat dissipating board are in discord with each other in Fig. 9, wherein Fig. 11(a) is a sectional view of the heat dissipating board, and Fig. 11(b) is a bottom view of the heat dissipating board as seen from the heat dissipating member.

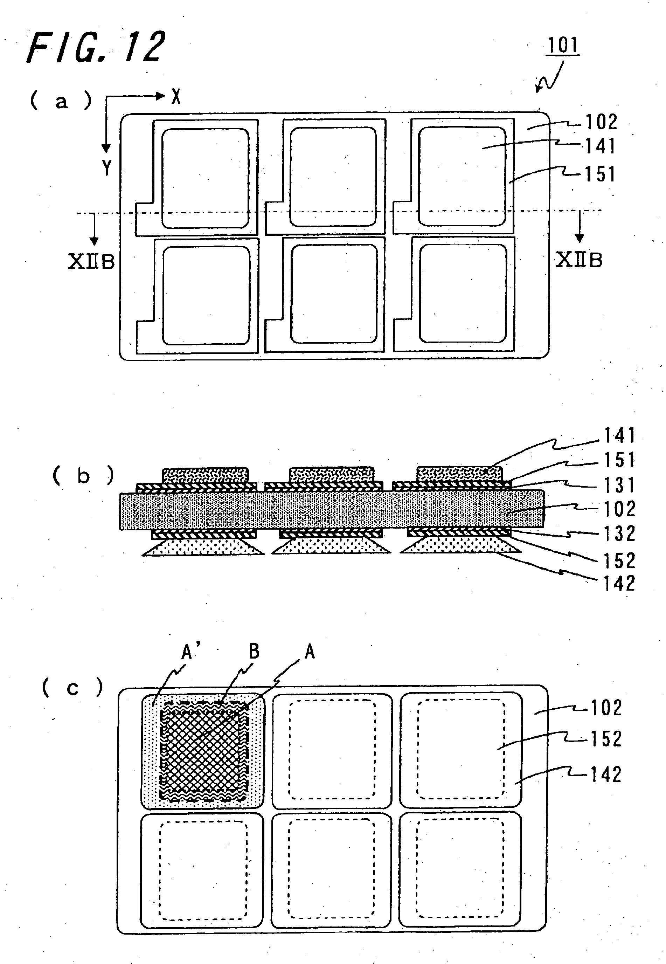

Fig. 12 is a diagram showing a heat dissipating board in accordance with still another embodiment of the invention, wherein Fig. 12(a) is a plan view of the heat dissipating board as seen from the circuit member, Fig. 12(b) is a sectional view taken along the line XIIB-XIIB depicted in Fig. 12(a), and Fig. 12(c) is a bottom view of the heat dissipating board as seen from the heat dissipating member.

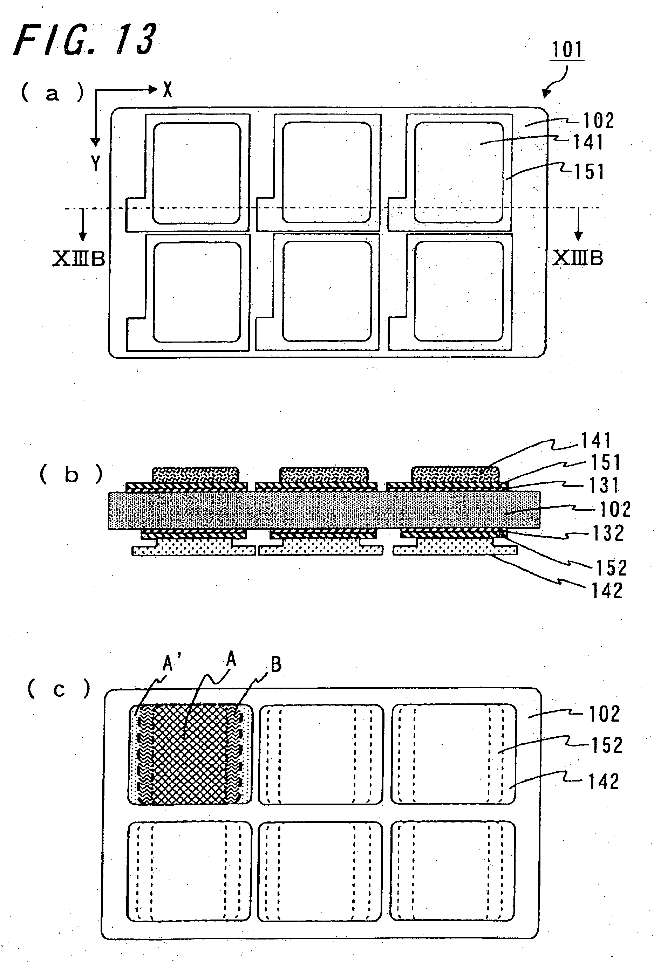

Fig. 13 is a diagram showing a heat dissipating board in accordance with still another embodiment of the invention, wherein Fig. 13(a) is a plan view of the heat dissipating board as seen from the circuit member, Fig. 13(b) is a sectional view taken along the line XIIIB-XIIIB depicted in Fig. 13(a), and Fig. 13(c) is a bottom view of the heat dissipating board as seen from the heat dissipating member.

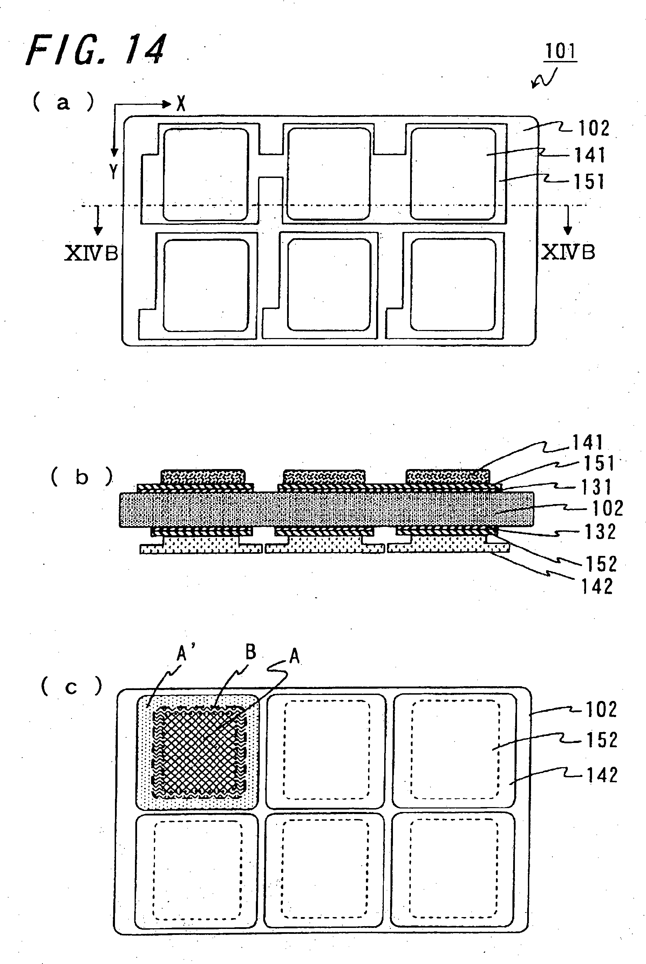

Fig. 14 is a diagram showing a heat dissipating board in accordance with still another embodiment of the invention, wherein Fig. 14(a) is a plan view of the heat dissipating board as seen from the circuit member, Fig. 14(b) is a sectional view taken along the line XIVB-XIVB depicted in Fig. 14(a), and Fig. 14(c) is a bottom view of the heat dissipating board as seen from the heat dissipating member.

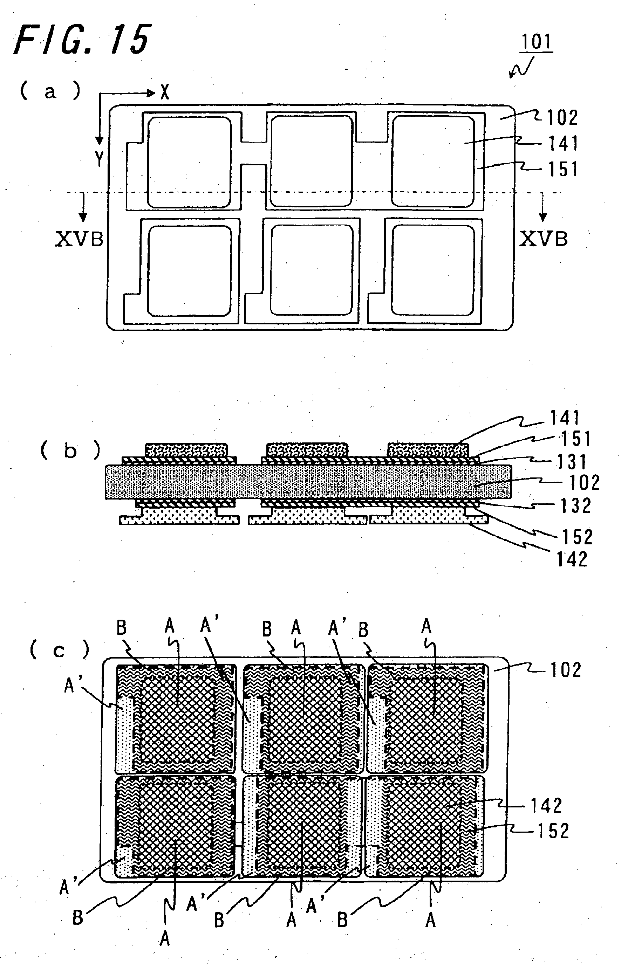

Fig. 15 is a diagram showing a heat dissipating board in accordance with still another embodiment of the invention, wherein Fig. 15(a) is a plan view of the heat dissipating board as seen from the circuit member, Fig. 15(b) is a sectional view taken along the line XVB-XVB depicted in Fig. 15(a), and Fig. 15(c) is a bottom view of the heat dissipating board as seen from the heat dissipating member.

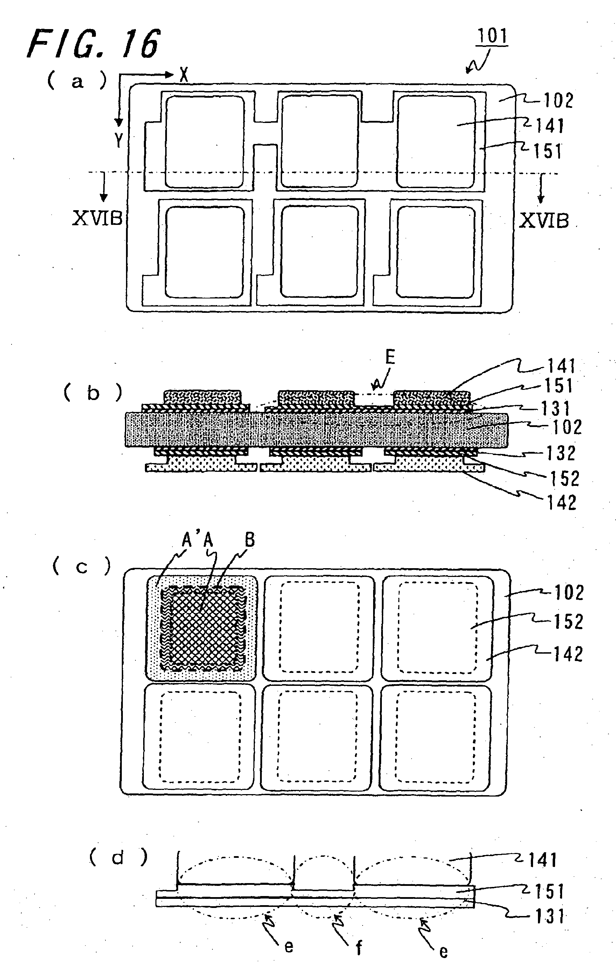

Fig. 16 is a diagram showing a heat dissipating board in accordance with another embodiment of the invention, wherein Fig. 16(a) is a plan view of the heat dissipating board as seen from the circuit member, Fig. 16(b) is a sectional view taken along the line XVIB-XVIB depicted in Fig. 16(a), and Fig. 16(c) is a bottom view of the heat dissipating board as seen from the heat dissipating member.

Reference signs list

1: Heat dissipating board
2: Ceramic substrate
31, 32: Active metal layer
41: Circuit member
42: Heat dissipating member
51, 52: Bonding layer

Best mode for carrying out the Invention

Hereinafter, embodiments of the invention will be described with reference to the accompanying drawings.

As shown in Figs. 1(a) to 1(c) and Fig. 2, a heat dissipating board 1 of the present embodiment comprises a ceramic substrate 2, at least one circuit member 41, a metal layer 22, and at least one heat dissipating member 42. The circuit member 41 is disposed on a first substrate main surface 2a which is a first main surface of the ceramic substrate 2. The metal layer 22 is disposed on a second substrate main surface 2b which is a second main surface of the ceramic substrate 2. The heat dissipating member 42 has a first surface A and a second surface A' located on an opposite side of the first surface A. The first surface A is kept in contact with the metal layer 22.

On the first substrate main surface 2a of the ceramic substrate 2 is disposed a metal layer 21. On the metal layer 21 is disposed the circuit member 41. It is preferable that the metal layer 21 is similar in structure and characteristic to the metal layer 22. Although only the metal layer 22 will hereafter be described, the description thereof may hold true for the metal layer 21.

The metal layer 22 functions as a heat transmitting member for transmitting heat emanating from the ceramic substrate 2 to the heat dissipating member 42. The metal layer 22 is not limited to a single layer. For example, as shown in Fig. 1, the metal layer 22 has a first metal layer 32 and a second metal layer 52. For example, the first metal layer 32 may be an active metal layer, whereas the second metal layer 52 may be a bonding layer. That is, by virtue of the two-layer structure, the strength of bonding between the ceramic substrate 2 and the heat dissipating member 42 can be increased. Similarly, as shown in Fig. 1, the metal layer 21 has a first metal layer 31 and a second metal layer 51.

The ceramic substrate 2 may comprise primarily silicon nitride, aluminum nitride, or alumina (50% by mass or above). In particular, the use of silicon nitride as a major constituent makes it possible to attain satisfactory heat dissipation characteristics, high mechanical strength, and so forth. Note that the thermal conductivity of silicon nitride is greater than or equal to 40 W/(m·k). To be specific, it is preferable that, given the ceramic substrate 2's total mass of 100% by mass, then the ceramic substrate 2 shall contain at least 80% by mass or above of silicon nitride. Moreover, as another additive component, out of erbium oxide, magnesium oxide, silicon oxide, molybdenum oxide, aluminum oxide, and the like, one or more of them is contained in the ceramic substrate 2. The first metal layer 32 contains an active metal. The second metal layer 52 primarily comprises copper.

By designing each of the main surfaces 2a and 2b of the ceramic substrate 2 to have a skewness (Rsk) of greater than 0 but smaller than or equal to 0.2, it is possible to achieve satisfactory bonding of the active metal layers 31 and 32 that are disposed on the main surfaces 2a and 2b, respectively, of the ceramic substrate 2. Note that the skewness can be derived in conformity with JIS B 0601-2001.

It is preferable that the ceramic substrate 2 has the following mechanical properties: Three-point bending strength of 650 MPa or above; a Young's modulus of 300 GPa or above; a Vickers hardness (Hv) of 13 GPa or above; and a fracture toughness ($K_{1C}$) of 5 MPam$^{1/2}$ or above. By designing the ceramic substrate 2 to have such mechanical properties falling in the aforementioned ranges, it is possible to improve its creep resistance and durability to withstand heat cycle.

In regard to the three-point bending strength, after the first metal layers (hereafter referred to as the "active metal layers") 31 and 32, the second metal layers (hereafter referred to as the "bonding layers") 51 and 52, the circuit member 41, and the heat dissipating member 42 are removed from the heat dissipating board 1 by means of etching, a three-point bending strength measurement is conducted in conformity with JIS R 1601-1995. However, in a case where the thickness of the ceramic substrate 2 is so small that it is impossible for a test piece cut from the ceramic substrate 2 to have a thickness of 3 mm, the thickness of the test piece may correspond to the thickness of the ceramic substrate 2 per se.

In regard to the Young's modulus, after the active metal layers 31 and 32, the bonding layers 51 and 52, the circuit member 41, and the heat dissipating member 42 are removed from the heat dissipating board 1 by means of etching, a Young's modulus measurement is conducted in conformity with JIS R 1602-1995.

The Vickers hardness (Hv) and the fracture toughness ($K_{1C}$) are measured in accordance with the Indentation Fracture methods (IF method) defined by JIS R 1610-2003 and JIS R 1607-1995, respectively.

In terms of electrical properties, the ceramic substrate 2 should preferably be built as an insulating substrate which has a volume resistivity value of $10^{14}$ $\Omega$·cm or above at room temperatures and has a volume resistivity value of $10^{12}$ $\Omega$·cm or above at 300°C.

It is preferable that the Vickers hardness Hv of the metal layer 21, 22 or the bonding layer 51, 52 is smaller than or equal to 0.5 GPa. In this case, deformation is caused easily at the time of bonding the circuit member 41 and the heat dissipating member 42, wherefore the circuit member 41 and the heat dissipating member 42 having a large thickness can be bonded satisfactorily.

Moreover, in a case where the circuit member 41 is made higher in hardness than the heat dissipating member 42, the circuit member 41 exhibits higher rigidity when compared to the heat dissipating member 42. This makes it possible to lessen the degree of warpage occurring in the heat dissipating board 1.

It is advisable that the circuit member and/or the heat dissipating member should comprise primarily copper or an alloy of copper.

For example, the active metal layers 31 and 32 are each made of a Ag-Cu alloy which contains at least one active metal element of Group 4 elements or Group 5 elements such as titanium (Ti), zirconium (Zr), hafnium (Hf), and vanadium (V).

The bonding layers 51 and 52 stacked on the active metal layers 31 and 32, respectively, permit firm bonding of the active metal layer 31 with the circuit member 41 and firm bonding of the active metal layer 32 with the heat dissipating member 42, respectively. The bonding layers 51 and 52 each primarily comprise copper. By the effect of diffusion of copper or copper alloy contained in the bonding layers 51 and 52, the circuit member 41, and the heat dissipating member 42, it is possible to achieve firm bonding of the circuit member 41 and the heat dissipating member 42, which are bonded to the upper surface of the bonding layer 51 and the lower surface of the bonding layer 52, respectively, at a temperature as low as 300 to 500°C. The bonding layers 51 and 52 primarily comprises copper which is low in terms of yield stress and also have a small thickness, and can thus become deformed easily. This makes it possible to achieve bonding under a small load. Moreover, a thermal stress produced in the course of cooling process can be alleviated by the deformation of the bonding layers 51 and 52. Accordingly, even with the bonding to them of the circuit member 41 and the heat dissipating member 42 each having a larger thickness, warpage will not occur easily.

It is advisable that each of the bonding layers 51 and 52 should contain copper as a major constituent in an amount of greater than or equal to 99.96% by mass. As the copper, out of oxygen-free copper, tough pitch copper, phosphorus deoxidized copper, and the like, one or more of them may be used. It is particularly desirable to use, out of oxygen-free copper elements, any of linear crystal oxygen-free copper, single crystal high-purity oxygen-free copper, and vacuum melted copper having a copper content of greater than or equal to 99. 995% by mass.

The circuit member 41 and the heat dissipating member 42 each primarily comprise copper or an alloy of copper (the content of Cu is greater than or equal to 72% by mass). It is advisable that each of the circuit member 41 and the heat dissipating member 42 should contain copper or an alloy of copper in an amount of greater than or equal to 90.0% by mass. As the copper, oxygen-free copper, tough pitch copper, phosphorus deoxidized copper, and the like may be used. It is particularly desirable to use, out of oxygen-free copper elements, any of linear crystal oxygen-free copper, single crystal high-purity oxygen-free copper, and vacuum melted copper having a copper content of-greater than or equal to 99. 995% by mass.

As to the shape of the ceramic substrate 2, for example, on the basis of the X-Y rectangular coordinate system as shown in Fig. 1, the length of the ceramic substrate 2 in the X direction (longitudinal direction) is set to fall in a range of from 30 to 80 mm, and the length thereof in the Y direction (transverse direction) is set to fall in a range of from approximately 10 to 80 mm. The thickness of the ceramic substrate 2, though it varies depending upon application purposes, is set to fall in a range of from approximately 0.13 to 0.4 mm, with consideration given to thermal resistance and durability. As to the active metal layer 31, for example, with respect to the line IB-IB, the length of the active metal layer 31 per piece in the X direction is set to fall in a range of from 12.4 to 24.4 mm, the length thereof in the Y direction is set to fall in a range of from 16.4 to 20.4 mm, and the thickness thereof is set to fall in a range of from 10 to 20 $\mu$m. Moreover, as to the active metal layer 32, for example, with respect to the line IB-IB, the length of the active metal layer 32 per piece in the X direction is set to fall in a range of from 12.4 to 22.4 mm, the length thereof in the Y direction is set to fall in a range of from 16.4 to 24.4 mm, and the thickness thereof is set to fall in a range of from 10 to 20 $\mu$m.

An intermediate layer may be disposed between the bonding layer 52 and the heat dissipating member 42. The intermediate layer may comprise primarily one of the following metal elements: Au, Pt, Ag, In, and Sn. The content of the major constituent in the intermediate layer accounts for 90% or above by mass relative to the intermediate layer as a whole. The thickness of the intermediate layer may be set at or below 10 nm. Moreover, the intermediate layer may have two or more layer portions. In this case, for example, a first thin layer is formed on the bonding layer 51, 52, and on the first thin layer is formed a second thin layer. The first thin layer and the second thin layer may be formed of a metal material as described hereinabove. Further, the thickness of each of the first thin layer and the second thin layer may be set at or below 10 nm. In this way, the bonding layer 52 and the heat dissipating member 42 can be bonded to each other at a low temperature. The first thin layer and the second thin layer may be formed of the same metal material. Particularly in a case where the first thin layer and the second thin layer each primarily comprise Sn, the bonding can be achieved at a temperature as low as approximately 180 to 300°C. It is advisable that a surface of the first thin layer acting as an interface between the first thin layer and the second thin layer should have an arithmetic average height Ra of smaller than or equal to 0.2 $\mu$m. This makes it possible to achieve satisfactory bonding of the first thin layer with the second thin layer while lessening the degree of warpage in the heat dissipating board 1. Note that the intermediate layer may be disposed between the bonding layer 51 and the circuit member 41. Also in this case, the same effects as described just above can be achieved.

It is advisable that the length of the circuit member 41 in the X direction, or the longitudinal direction, and the length thereof in the Y direction, or the transverse direction, should be greater than or equal to 80% but smaller than 100% of the length of the circuit member 41-sided bonding layer 51 in the X direction and the length thereof in the Y direction, respectively. For example, the length of the circuit member 41 per piece in the X direction is so selected as to fall in a range of from 10 to 17 mm, and the length thereof in the Y direction is so selected as to fall in a range of from 10 to 20 mm. Moreover, in accordance with the magnitude of electric current which passes through the circuit and the amount of heat which is generated in an electronic component such as a semiconductor device mounted on the circuit member 41, the thickness of the circuit member 41 is so selected as to fall in a range of from 0.5 to 5 mm. It is also advisable that the X-direction length and the Y-direction length of a bonding layer 52-sided surface A of the heat dissipating member 42 should be greater than or equal to 80% but smaller than 100% of the X-direction length and the Y-direction length, respectively, of the bonding layer 52. A surface A' located on an opposite side of the surface A is larger than the surface A. The circuit member 41 constitutes a circuit for establishing electrical connection of an electronic component such as a semiconductor device mounted on the circuit member 41. The heat dissipating member 42 acts to facilitate a heat dissipating action for dissipating heat emanating from the electronic component to the outside.

Upon actuation of the electronic component such as a semiconductor device mounted on the circuit member 41, the temperature of the electronic component is increased to approximately 50 to 70°C. Since the surface A of the heat dissipating member 42 is smaller in area than a surface B of the bonding layer 52, it follows that a space is present in a boundary region between the surface B of the bonding layer 52 and the surface A of the heat dissipating member 42. Therefore, the heat dissipating member 42 becomes deformed easily. Even if application of heat and dissipation of heat are repeated relatively in the electronic component such as a semiconductor device, by virtue of the presence of the space and the deformation of the heat dissipating member 42 in itself, an induced thermal stress can be dispersed efficiently. This makes it possible to reduce a residual stress resulting from a difference in thermal expansion coefficient between the heat dissipating member 42 and the ceramic substrate 2. As a consequence, the occurrence of cracking ascribable to the residual stress can be reduced in the ceramic substrate 2. The heat emanating from the electronic component such as a semiconductor device mounted on the circuit member 41 is dissipated toward a heat sink (not shown) disposed on the lower surface of the heat dissipating member 42. At this time, the heat is conducted and transferred while being diffused as indicated by a line D shown in Fig. 1(b). That is, the heat is transmitted from the main surface of the circuit member 41 toward the end of the surface A'. Since the surface A' is larger in area than the surface B, it is possible to dissipate the heat generated in the electronic component toward the surface A' efficiently and thereby improve the heat dissipation characteristics of the heat dissipating member 42.

It is preferable that the heat dissipating member 42 is so shaped that its length in the longitudinal direction is increased stepwise or gradually from the surface A to the surface A'. The longitudinal length of the heat dissipating member 42 can be checked for example by viewing the heat dissipating member 42 in section in a direction perpendicular to the main surface of the heat dissipating board 1 shown in Fig. 1(b). As shown in Fig. 1(b), in a case where the longitudinal length L of the heat dissipating member 42 is increased stepwise from the surface A to the surface A', there is present a space communicating with outside air between the surface A and the surface B. Moreover, since the surface area of the end face of the heat dissipating member 42 can be increased, it follows that the heat emanating from the electronic component such as a semiconductor device mounted on the circuit member 41 can be easily dissipated from the end face. Further, the heat is transmitted along the line D to each of the constituent members, wherefore heat dissipation can be achieved more efficiently.

It is preferable that, as shown in Fig. 2, the heat dissipating member 42 has a notch portion C formed on the surface A thereof. That is, the heat dissipating member 42 is provided with the surface A which is brought into contact with the metal layer 22, the surface A' acting as a heat dissipating surface, and the notch portion C. In this way, it is desirable to provide such a shoulder portion obtained by cutting away part of the heat dissipating member at the end of the edge of the surface A in the thickness direction. With the provision of the notch portion C, the volume of the heat dissipating member 42 can be reduced, and an induced thermal stress can be alleviated by the shoulder portion. As a consequence, the likelihood of ceramic substrate 2 breakage can be reduced. In addition, a space 62 (refer to Fig. 1) can be created between the metal layer 22 and the heat dissipating member 42. Since the space 62 (refer to Fig. 1) communicates with outside air, it is possible to enhance the heat dissipation capability of the heat dissipating member 42.

The shoulder portion of the heat dissipating member 42 can be formed by cutting away part of the heat dissipating member about the surface A in the thickness direction, with consideration given to the kind of the electronic component mounted on the circuit member 41, the shape and dimension of the heat dissipating board 1, and so forth.

In each of Figs. 3 to 5, there is shown the heat dissipating member 42 of another type for use in the heat dissipating board in accordance with the embodiment of the invention. The heat dissipating member 42 as shown in Fig. 3 has the shape of a truncated quadrangular pyramid, and its slanting faces connecting the surface A with the surface A' are each made as a flat surface. In other words, in Fig. 3(b), the surface A and the surface A' are connected to each other by a straight line.

The heat dissipating members 42 as shown in Figs. 4 and 5, respectively, too have the shape of a truncated quadrangular pyramid, but they differ from the heat dissipating member 42 shown in Fig. 3 in terms of the profile of slanting faces, and more specifically they have convex slanting faces and concave slanting faces, respectively. As shown in Figs. 3 to 5, it is preferable that the heat dissipating member 42 is so shaped that its longitudinal length L is increased gradually from the surface A toward the surface A'.

Since the surface area of the end face of the heat dissipating member 42 can be increased, it follows that the heat emanating from the electronic component such as a semiconductor device mounted on the circuit member 41 can be dissipated easily from the end face. Moreover, the heat is transmitted along the line D to each of the constituent members, wherefore heat dissipation can be achieved more efficiently.

In Fig. 6, there is shown the heat dissipating member 42 in which each of the regions extending from the surface A' to the surface A has a vertical portion and an inclined portion. The lower part of this construction is shaped as a rectangular prism, whereas the upper part thereof is, just like the construction shown in Fig. 3, shaped as a truncated quadrangular pyramid. That is, this heat dissipating member is shaped so as to include a rectangular prism and a truncated quadrangular pyramid placed thereon. Also with this shape, the same effects as achieved in the constructions shown in Figs. 2 to 5 can be achieved.

Note that, as to the stepwise increase of the length L as stated herein, the length L is preferably varied within a range of ±10% or below, and more preferably within a range of ±3% or below.

As shown in Fig. 1, the heat emanating from the electronic component such as a semiconductor device is transmitted toward the heat dissipating member 42 shown in Figs. 3 to 6 just as is the case with the heat dissipating member 42 shown in Fig. 2; that is, propagates in the direction from the top surface of the heat dissipating board 1 on which is mounted the electronic component to the surface A', as indicated by the line D, so as to eventually reach the end portion of the heat dissipating board. By forming at least part of the heat dissipating member 42 as a slanting face which is inclined from the surface A toward the surface A' along the line D; that is, by shaping the heat dissipating member 42 as a truncated pyramid, it is possible to allow heat to propagate unobstructed substantially in parallel with the slanting face of the heat dissipating member 42, and thereby enhance the heat dissipation characteristics even further. Moreover, since the heat dissipating member 42 can be produced by an inexpensive method such as stamping, it is possible to provide the heat dissipating board 1 at low cost. In this case, the slanting face of the truncated pyramid is made as nearly parallel to the line D as possible, with consideration given to the kind of the electronic component to be mounted, the shape and dimension of the heat dissipating board 1, and so forth.

In a heat dissipating board 101 as shown in Fig. 12, a surface A of a heat dissipating member 142 is so designed that the long edge and the short edge thereof are shorter than the long edge and the short edge, respectively, of a surface B of a bonding layer 152. In this way, the surface A is made smaller in area than the surface B. Moreover, a surface A' of the heat dissipating member 142 is so designed that the long edge and the short edge thereof are longer than the long edge and the short edge, respectively, of the surface B of the bonding layer 152. In this way, the surface A' is made larger in area than the surface B. On the other hand, in the heat dissipating board 101 as shown in Fig. 13, the surface A of the heat dissipating member 142 is so designed that only the short edge thereof is shorter than the short edge of the surface B of the bonding layer 152. In this way, the surfaces is made smaller in area than the surface B. Moreover, the surface A' of the heat dissipating member is so designed that only the short edge thereof is longer than the short edge of the surface B of the bonding layer. In this way, the surface A' is made larger in area than the surface B.

Note that there will arise no inconvenience at all even if, alternatively, the surface A of the heat dissipating member 142 is so designed that only the long edge thereof is shorter than the long edge of the surface B of the bonding layer 152 to render the area of the surface A smaller than the area of the surface B, and also the surface A' of the heat dissipating member 142 is so designed that only the long edge thereof is longer than the long edge of the surface B of the bonding layer 152 to render the area of the surface A' larger than the area of the surface B.

In the heat dissipating board 101 as shown in Fig. 14, a bonding layer 151 is so formed as to extend in places over a plurality of circuit members 141. In this construction, the bonding layer 151 serves as a wiring line for establishing connection between a plurality of the circuit members 141. This makes it possible to eliminate the need to install wire interconnection and thereby achieve the simplification of wiring.

In the heat dissipating board 101 as shown in Fig. 15, two layers, namely active metal layers 131 and 132 are arranged in a substantially plane-symmetrical relation to each other with respect to a ceramic substrate 102, and so are another two layers, namely the bonding layers 151 and 152, and so are the circuit member 141 and the heat dissipating member 142. The bonding layer 151 is so formed as to extend in places over a plurality of the circuit members 141, and also the bonding layer 152 is so formed as to extend in places over a plurality of the heat dissipating members 142. Fig. 11 is an enlarged sectional view of the heat dissipating member 142 shown in Fig. 15. In the heat dissipating board 101 shown in Fig. 15, the bonding layer 151 serves as a wiring line for establishing connection between a plurality of the circuit members 141, and the bonding layer 152 serves as a wiring line for establishing connection between a plurality of the heat dissipating members 142. This makes it possible to eliminate the need to install wire interconnection and thereby achieve further wiring simplification.

In the heat dissipating board 1 as shown in Fig. 16, just like the construction shown in Fig. 14, the bonding layer 151 is so formed as to extend in places over a plurality of the circuit members 141. The thickness of the bonding layer 151 varies from part to part, and more specifically, as compared with a region thereof in which is placed the circuit member 141, being called the circuit member placement region (e), a region thereof located between the adjacent circuit members 141, being called the inter-circuit member region (f) is made thinner. This makes it possible to control the direction of warpage which occurs in the heat dissipating board 101 in such a manner that the heat dissipating board 101 is curved convexly toward the heat dissipating member 142, wherefore the heat dissipation characteristics of the heat dissipating board 101 can be enhanced. It is especially preferable that the bonding layer 151 is so designed that the difference in thickness between the circuit member placement region (e) and the inter-circuit member region (f) is greater than or equal to 200 μm.

As shown in Fig. 7, the heat dissipating board 101 of the present embodiment comprises a single ceramic substrate 102, a plurality of circuit members 141, a plurality of metal layers 122, and a plurality of heat dissipating members 142. The circuit member 141 is disposed on a first substrate surface 102a which is a first main surface of the ceramic substrate 102. The metal layer 122 is disposed on a second substrate main surface 102b which is a second main surface of the ceramic substrate 102. The heat dissipating member 142 has a first surface A and a second surface A' located on an opposite side of the first surface A. The first surface A is kept in contact with the metal layer 122.

On the first substrate main surface 102a of the ceramic substrate is disposed a metal layer 121. On the metal layer 121 is disposed the circuit member 141. It is preferable that the metal layer 121 is similar in configuration and characteristic to the metal layer 122.

A plurality of the heat dissipating members 142 are arranged in the form of a matrix consisting of two rows and three columns. For example, the dimensions of the heat dissipating member 42 per piece, namely the X-direction length in respect of the surface A, the Y-direction length in respect of the surface A, the X-direction length in respect of the surface A', the Y-direction length in respect of the surface A', and the thickness, may respectively be 10 to 20 mm, 10 to 25 mm, 10 to 30 mm, 10 to 35 mm, and 0.5 to 5 mm. Note that, in a case where the X-direction length and the Y-direction length in respect of the surface A are each set at 10 mm, at least one of the X-direction length and the Y-direction length in respect of the surface A' is set to be longer than 10 mm.

By arranging the heat dissipating members 142 in the form of a matrix consisting of a plurality of rows and columns in that way, it is possible to shape the ceramic substrate 102 as a square or a nearly-square rectangle, and thereby lessen the degree of warpage occurring in the heat dissipating board 101. Note that there is no particular limitation to the number of rows and columns, and therefore a combination of rows and columns of any given number may be adopted.

It is desirable to dispose a plurality of the circuit members 141 just as is the case with the heat dissipating members 142. Moreover, for the same reason as described above, it is desirable to arrange the circuit members 141 in the form of a matrix consisting of a plurality of rows and columns. In particular, by arranging the circuit member 141 and the heat dissipating member 142 in a symmetrical manner with respect to the ceramic substrate, it is possible to lessen the degree of warpage occurring in the heat dissipating board 101 even further.

Now, the reason that the warpage of the heat dissipating board can be suppressed by the features of the heat dissipating member 142 will be described with reference to Fig. 8. In each instance, the warpage of the heat dissipating board 101 may be illustrated practically as the warpage of the ceramic substrate 102. In the ceramic substrate 102 as shown in Fig. 8, in either of the instances (a) and (b), the circuit members 141 and the heat dissipating members 142 are so arranged that the total sum of the volumes of the circuit members 141 and the total sum of the volumes of the heat dissipating members 142 are equal per a single heat dissipating board. Fig. 8(a) shows an instance where the circuit members 141, as well as the heat dissipating members 142, are arranged in the form of a matrix consisting of a plurality of rows and a plurality of columns. Fig. 8(b) shows an instance where the circuit members 141, as well as the heat dissipating members 142, are arranged in the form of a matrix consisting of one row and a plurality of columns. In the instance as shown in Fig. 8(a), the arrangement may take on the shape of a square or a nearly-square rectangle. When these instances are equal in radius of curvature (R), then a warpage (H1) occurring in a ceramic substrate 102a as shown in Fig. 8(a) can be smaller than a warpage (H2) occurring in a ceramic substrate 102b as shown in Fig. 8(b).

Next, a description will be given as to the relationship in arrangement among the surface A, the surface A', and the surface B that is established in the case of arranging the heat dissipating members in the form of a matrix.

In Fig. 9, there is shown a pair of the metal layer 122 and the heat dissipating member 142. As shown in Fig. 9(a), the heat dissipating member shown in Fig. 2 is used for the pair. As shown in Fig. 9(b), the center of the surface B of the metal layer 122 (the bonding layer 152 in reality) is defined as "O". On the other hand, the centers of, respectively, the surface A and the surface A' of the heat dissipating member 142 are each defined as "O'". That is, the heat dissipating member 142 is so shaped that the surface A has a longitudinal length of $L_1$ and a transverse length of $W_1$, and the metal layer 122 is so shaped as to have a longitudinal length of $L_2$ and a transverse length of $W_2$.

A distance between the center O of the surface B and the center O' of the surface A in the longitudinal direction and that in the transverse direction are defined as "a" and "b", respectively. The stress relaxation characteristics vary according to the distance a and the distance b as well.

The longer is the distance a as well as the distance b, the greater is the extent to which an induced thermal stress is alleviated in the longitudinal direction and the transverse direction in an imbalanced manner. In contrast, the shorter is the distance a as well as the distance b, the greater is the extent to which an induced thermal stress is alleviated in the longitudinal direction and the transverse direction in a well-balanced manner. In Fig. 10, there is shown a case where the center O of the surface B and the center O' of the surface A coincide with each other; that is, both of the distance a and the distance b take on a zero value. In this case, a thermal stress can be alleviated effectively.

In view of the foregoing, the distance a and the distance b are adjusted to fall in the ranges defined by the following expressions (1) and (2), respectively. By doing so, it is possible to allow the metal layer 122 to become deformed easily during cooling in the course of a bonding step, and thereby alleviate an induced thermal stress in the longitudinal direction and the transverse direction in a well-balanced manner. Accordingly, the likelihood of ceramic substrate 102 breakage can be reduced even further.

It is especially preferable that the heat dissipating board 101 is designed to satisfy both of the expressions (1) and (2). In this case, the likelihood of ceramic substrate 102 breakage can be reduced to a larger extend than in a case where only one of the expressions (1) and (2) is satisfied. Note that the relational expressions may hold true for the case as shown in Fig. 1 where there is provided only a single heat dissipating plate.

$$0 \leq a \leq (L_2 - L_1)/2 \qquad (1)$$

where
$L_1$ represents the longitudinal length of the surface A of the heat dissipating member; and
$L_2$ represents the longitudinal length of the surface B of the bonding layer.

$$0 \leq b \leq (W_2 - W_1)/2 \qquad (2)$$

where
$W_1$ represents the transverse length of the surface B of the heat dissipating member; and
$W_2$ represents the transverse length of the surface B of the bonding layer.

Next, a method for manufacturing the heat dissipating board in accordance with the present embodiment will be described below.

Referring to Fig. 1, for example, the heat dissipating board 1 is fabricated as follows. At first, a paste of a Ag-Cu alloy, which contains at least one active metal element of Group 4 elements or Group 5 elements such as titanium (Ti), zirconium (Zr), hafnium (Hf), and vanadium (V), is applied onto both of the main surfaces of the ceramic substrate 2 which is 30 to 80 mm in length, 10 to 80 mm in width, and 0.13 to 0.4 mm in thickness by means of screen printing, a roll coater technique, a brush coating technique, or otherwise. Then, on the paste is laminated a 0.1 to 0.6 $\mu$m-thick copper foil comprising primarily copper, and the laminated body is subjected to a heating process at a temperature of 800 to 900°C. In this way, the active metal layers 31 and 32 and the bonding layers 51 and 52 comprising primarily copper are formed.

Next, the surface of the bonding layer 51 that is brought into contact with the circuit member 41 and the surface of the bonding layer 52 that is brought into contact with the heat dissipating member 42 are each polished. After that, in an atmosphere selected from among reducing gases or inert gases such as hydrogen, nitrogen, neon, argon, and so forth, the workpiece is heated to a temperature of 300 to 500°C. Moreover, under a pressure of greater than or equal to 30 MPa, the circuit members 41 and the heat dissipating members 42, whose surfaces to be bonded to their respective bonding layers 51 and 52 are made flat, are arranged in the form of, for example, a matrix consisting of three rows and two columns or a matrix consisting of three rows and three columns and are then subjected to bonding, whereupon the heat dissipating board 1 is obtained.

In a case where the heat dissipating member 42 is so designed that at least a part thereof constitutes a slanting face C' extending from the surface A to the surface A and thus takes on a truncated pyramid shape, in order to obtain the shape, a stamping operation is carried out in advance. On the other hand, in a case where the heat dissipating member 42 is formed with a shoulder portion created by cutting away part of the heat dissipating member about the surface A in the thickness direction, in order to obtain the shoulder portion, a milling operation is carried out in advance.

Then, the heat dissipating board 1 is cooled down to a temperature at which copper and copper alloys will not be oxidized (50°C) while being pressurized. Upon this temperature being reached, the pressurization is brought to an end and the heat dissipating board 1 is taken out.

Note that, as shown in Figs. 16(a) to 16(c), in order to form the bonding layer 151 so as to provide connection among a plurality of the circuit members 141 and also, as shown in Fig. 16(d), in order to form the bonding layer 151 in such a manner that its thickness varies from part to part, and more specifically, the inter-circuit member region (f) is made thin compared with the circuit member placement region (e), following the fabrication of the construction in accordance with the method as described hereinabove, the bonding layer 151 is subjected to etching, laser processing, or the like operation, with the areas thereof other than the area corresponding to the inter-circuit member region (f) kept masked, so that the inter-circuit member region (f) can be processed into a thin region. After that, the masking material for use is removed, whereupon the heat dissipating board 101 can be obtained.

The heat dissipating board 1 can be used as a suitable heat dissipating board when it employs the circuit member 41 comprising primarily copper or an alloy of copper. As to how the circuit is to be formed, specifically, the following ways may be adopted, i.e. the use of a copper plate having a circuit formed by defining therein a pattern in advance by means of press working or etching; and the implementation of patterning by means of etching, laser processing, or otherwise following the completion of bonding of the circuit member.

As will be understood from the foregoing, according to the heat dissipating board 1 of the present embodiment, in contrast to the case of performing a bonding process by a copper direct bonding method, a metallization method utilizing metal having a high melting point, an active metal brazing method, or the like, it is possible to lessen the degree of warpage occurring in the circuit member 41 and in the heat dissipating member 42 during bonding, and thereby increase the thicknesses of, respectively, the circuit member 41 and the heat dissipating member 42. The heat dissipating board 1 in which both the circuit member 41 and the heat dissipating member 42 have a large thickness is able to offer enhanced heat dissipation characteristics and may be, in some cases, in no need of attachment of the heat sink (not shown).

By mounting the electronic component such as a semiconductor device on the circuit member 41 disposed in the heat dissipating board 1, it is possible to effectively suppress accumulation of heat in the electronic component even during the use of an electronic apparatus such as a semiconductor apparatus.

Hence it follows that the heat dissipating board 1 of the present embodiment is excellent in heat dissipation characteristics as heretofore described and is therefore applicable to a substrate for use in a dye-sublimation type thermal printer head, a planar heat generating heater support substrate, a heater support substrate for use in a thermal ink jet printer head, and so forth. Moreover, according to the present embodiment, in the case of mounting an electronic component on the circuit member 41, accumulation of heat in the electronic component can be suppressed. This makes it possible to provide an electronic apparatus, such as a power module, having high-level heat dissipation characteristics.

The electronic apparatus in accordance with the embodiment of the invention is constructed by mounting an electronic component on the circuit member 41 of the heat dissipating board 1. Even if the electronic component mounted on the circuit member produces heat, the heat accumulated in the electronic component can be reduced, wherefore it is possible to provide an electronic apparatus, such as a power module, having high-level heat dissipation characteristics.

Examples

Next, Examples of the invention will be described.

<Example 1>

There was fabricated the heat dissipating board as shown in Figs. 11 and 12. On the first substrate surface of the ceramic substrate are disposed the circuit members, and on the second substrate surface thereof are disposed the heat dissipating members. The circuit members, as well as the heat dissipating members, are arranged in the form of a matrix consisting of two rows and three columns.

First of all, on each of the main surfaces of the ceramic substrate 102 which has a size as shown in Table 1 and is made of a silicon nitride sintered body containing 84% by mass of silicon nitride, there was applied a coating of an Ag-Cu alloy paste containing titanium (Ti) that is formed into the active metal layer 131, 132 by means of screen printing. On the paste was laminated a copper foil made of oxygen-free copper that is formed into the bonding layer 151, 152. Subsequently, the laminated body has been heated at 850°C to form the active metal layer 131, 132 and the bonding layer 151, 152 made of oxygen-free copper. Then, the surface of the bonding layer 151 that is brought into contact with the circuit member 141 and the surface of the bonding layer 152 that is brought into contact with the heat dissipating member 142 have been polished with use of a lapping machine until they have an arithmetic average height Ra of smaller than or equal to 0.050 $\mu$m. After that, the workpiece has been heated in a hydrogen atmosphere, and then, under a pressure of 30 MPa, arrangement and bonding of the circuit members 141 and the heat dissipating members 142, whose surfaces to be bonded to their respective bonding layers 151 and 152 are made flat, were conducted. In this way, test samples of the heat dissipating board 101 numbered 1 through 8 were fabricated.

In each of the test samples numbered 1 through 8, the distance a between the longitudinal center of the surface B of the bonding layer 152 and the longitudinal center of the surface A of the heat dissipating member 142, and the distance b between the transverse center of the surface B of the bonding layer 152 and the transverse center of the surface A of the heat dissipating member 142 were each set at or below 10 $\mu$m.

Note that the meanings of the symbols listed in Table 1 will be set forth hereunder. Moreover, in Table 1, a heat dissipating board test sample in which the heat dissipating member 142 has a slanting face extending from the surface A toward the surface A' so as to take on a truncated pyramid shape as shown in Fig. 12 is represented as "Truncated pyramid", a heat dissipating board test sample in which the heat dissipating member 142 is formed with a shoulder portion obtained by cutting away part of the heat dissipating member about the surface A in the thickness direction as shown in Fig. 16 is represented as "Shoulder", and a heat dissipating board test sample in which the heat dissipating member 142 has the shape of a rectangular prism is represented as "Rectangular prism".

$S_A$ represents the area of the surface A of the heat dissipating member 142 that is contacted by the bonding layer 152;

$S_{A'}$ represents the area of the surface A' of the heat dissipating member 142;

$S_B$ represents the area of the surface B of the bonding layer 152;

$L_1$ represents the longitudinal length of the surface A of the heat dissipating member 142;

$L_{1'}$ represents the longitudinal length of the surface A' of the heat dissipating member 142;

$L_2$ represents the longitudinal length of the surface B of the bonding layer 152;

$W_1$ represents the transverse length of the surface A of the heat dissipating member 142;

$W_1$, represents the transverse length of the surface A' of the heat dissipating member 142; and

$W_2$ represents the transverse length of the surface B of the bonding layer 152.

The test samples numbered 1 through 8 were arranged within a testing chamber to perform environmental testing thereon in conformity with JIS C 0025-1988.

To be specific, following the arrangement of the test samples within the testing chamber, as one cycle of operation, the following steps were performed: raising the temperature of the interior of the testing chamber; leaving the testing chamber to stand for 30 minutes at 125°C; lowering the temperature of the interior of the testing chamber; and leaving the testing chamber to stand for 30 minutes at -40°C. The number of cycles counted at the time when cracking was observed in the ceramic substrate 2 of each test sample is listed in Table 1.

The presence or absence of cracking was checked by using an optical microscope at a magnification of 20 times.

In addition, another test samples of the heat dissipating board of the Example numbered 1 through 8 were fabricated separately in the same manner as that thus far described. In the test samples, a heat sink (not shown) made of aluminum was pressure-bonded to the bottom surface of the heat dissipating member 142 and thereafter a semiconductor device was mounted on the circuit member 141 to thereby fabricate an electronic apparatus.

Then, an electric current of 30 A has been passed through the semiconductor device, and, after a lapse of five minutes since the current passage, the surface temperature of the semiconductor device was measured by means of thermography. The surface temperature values are listed in Table 1 for evaluations of the heat dissipation characteristics of the heat dissipating boards.

Table 1

| No. | $S_A$ (mm$^2$) | $S_{A'}$ (mm$^2$) | $S_B$ (mm$^2$) | $L_1$ (mm) | $L_{1'}$ (mm) | $L_2$ (mm) | $W_1$ (mm) | $W_{1'}$ (mm) | $W_2$ (mm) | Heat dissipating member | Cycle number (cycles) | Surface temperature of semiconductor device (°C) |
|---|---|---|---|---|---|---|---|---|---|---|---|---|
| 1 | 336 | 644 | 500 | 21 | 28 | 25 | 16 | 23 | 20 | Truncated pyramid | 5000 | 70.1 |
| 2 | 374 | 644 | 500 | 22 | 28 | 25 | 17 | 23 | 20 | Truncated pyramid | 4000 | 68.3 |
| 3 | 456 | 644 | 500 | 24 | 28 | 25 | 19 | 23 | 20 | Truncated pyramid | 3200 | 66.4 |
| 4 | 336 | 644 | 500 | 21 | 28 | 25 | 16 | 23 | 20 | Shoulder | 6000 | 70.8 |
| 5 | 374 | 644 | 500 | 22 | 28 | 25 | 17 | 23 | 20 | Shoulder | 4500 | 68.8 |
| 6 | 456 | 644 | 500 | 24 | 28 | 25 | 19 | 23 | 20 | Shoulder | 3600 | 667 |
| 7 | 500 | 500 | 500 | 25 | 25 | 25 | 20 | 20 | 20 | Rectangular prism | 1000 | - |
| 8 | 729 | 729 | 500 | 27 | 27 | 25 | 27 | 27 | 20 | Rectangular prism | 500 | - |

As will be understood from Table 1, in each of the test samples numbered 1 through 6 in which the area $S_A$ of the surface A of the heat dissipating member 142 is smaller than the area $S_B$ of the surface B of the bonding layer 152 and also the area $S_{A'}$ of the surface A' is larger than the area $S_B$ of the surface B, cracking was observed for the first time over a course of at least as great as 3200th cycle. That is, the test samples numbered 1 through 6 have proven that they are less prone to occurrence of cracking.

The test sample No. 4, in particular, in which the heat dissipating member 142 is formed with a shoulder portion obtained by cutting away part of the heat dissipating member about the surface A in the thickness direction, gains an advantage over the test sample No. 1 which is equal in area $S_A$ and area $S_{A'}$ to the test sample No. 4 and in which the heat dissipating member 142 has a slanting face extending from the surface A to the surface A' so as to take on a truncated pyramid shape, in terms of the number of cycles counted at the time when cracking was observed for the first time. It has also been found on comparisons that, by the same token, the test sample No. 5 gains an advantage over the test sample No. 2, and the test sample No. 6 gains an advantage over the test sample No. 3.

As a result of heat dissipation characteristics evaluations, it has been found that the test sample No. 1 in which the heat dissipating member 142 has a slanting face extending from the surface A to the surface A' so as to take on a truncated pyramid shape is lower in semiconductor device's surface temperature than the test sample No. 4 which is equal in area $S_A$ and area $S_{A'}$ to the test sample No. 1 and in which the heat dissipating member 142 is formed with a shoulder portion obtained by cutting away part of the heat dissipating member about the surface A in the thickness direction. That is, the test sample No. 1 has proven that it gains an advantage over the test sample No. 4 in terms of heat dissipation characteristics. It has also been found on comparisons that, by the same token, the test sample No. 2 gains an advantage over the test sample No. 5, and the test sample No. 3 gains an advantage over the test sample No. 6.

In contrast, in the test sample No. 7 constructed by way of Comparative example in which the area $S_A$ of the surface A of the heat dissipating member 142 is equal to the area $S_{A'}$ of the surface A' of the heat dissipating member 142, after a run of 1000 cycles, cracking was observed in the ceramic substrate 102.

Furthermore, in the test sample No. 8 in which the area of the bonding layer 152-sided surface A of the heat dissipating member 142, the area of the surface A' of the heat dissipating member 142, and the area of the heat dissipating member 142-sided surface B of the bonding layer 152 are equal to one another, after a run of 500 cycles, cracking was observed in the ceramic substrate 102. It will thus be seen that, in contrast to the test samples numbered 1 through 6, both of the test sample No. 7 and the test sample No. 8 offer poor heat dissipation characteristics.

<Example 2>

There were fabricated test samples of the heat dissipating board numbered 9 through 18 in the same manner as adopted in Example 1. Following the completion of fabrication of the heat dissipating boards, the distance a between the longitudinal center of the surface B of the metal layer 122 and the longitudinal center of the surface A of the heat dissipating member 142, and the distance b between the transverse center of the surface B of the metal layer 122 and the transverse center of the surface A of the heat dissipating member 142 were measured by using an image measurement instrument, and measurement values are listed in Tables 2 and 3.

Note that the meanings of the symbols and the terms indicating the shape of the heat dissipating member 142 as set forth in Tables 2 and 3 are identical with those corresponding to Example 1.

The test samples numbered 9 through 18 were arranged within a testing chamber to perform environmental testing thereon in the same manner as adopted in Example 1. The number of cycles counted at the time when cracking was observed in the ceramic substrate 102 of each test sample is listed in Table 2. The presence or absence of cracking was checked by using an optical microscope at a magnification of 20 times.

Table 2

| No. | $S_A$ (mm²) | $S_{A'}$ (mm²) | $S_B$ (mm²) | $L_1$ (mm) | $L_{1'}$ (mm) | $L_2$ (mm) | $W_1$ (mm) | $W_{1'}$ (mm) | $W_2$ (mm) |
|---|---|---|---|---|---|---|---|---|---|
| 9 | 336 | 644 | 500 | 21 | 28 | 25 | 16 | 23 | 20 |
| 10 | 336 | 644 | 500 | 21 | 28 | 25 | 16 | 23 | 20 |
| 11 | 336 | 644 | 500 | 21 | 28 | 25 | 16 | 23 | 20 |
| 12 | 336 | 644 | 500 | 21 | 28 | 25 | 16 | 23 | 20 |
| 13 | 336 | 644 | 500 | 21 | 28 | 25 | 16 | 23 | 20 |
| 14 | 336 | 644 | 500 | 21 | 28 | 25 | 16 | 23 | 20 |
| 15 | 336 | 644 | 500 | 21 | 28 | 25 | 16 | 23 | 20 |

(continued)

| No. | $S_A$ (mm$^2$) | $S_{A'}$ (mm$^2$) | $S_B$ (mm$^2$) | $L_1$ (mm) | $L_{1'}$ (mm) | $L_2$ (mm) | $W_1$ (mm) | $W_{1'}$ (mm) | $W_2$ (mm) |
|---|---|---|---|---|---|---|---|---|---|
| 16 | 336 | 644 | 500 | 21 | 28 | 25 | 16 | 23 | 20 |
| 17 | 336 | 644 | 500 | 21 | 28 | 25 | 16 | 23 | 20 |
| 18 | 336 | 644 | 500 | 21 | 28 | 25 | 16 | 23 | 20 |

Table 3

| No. | $(L_2 - Li)/2$ (mm) | a (mm) | $(W_2 - W_1)/2$ (mm) | b (mm) | Heat dissipating member | Cycle number (cycles) |
|---|---|---|---|---|---|---|
| 9 | 2 | 0.1 | 2 | 0.1 | Truncated pyramid | 5000 |
| 10 | 2 | 0.5 | 2 | 0.1 | Truncated pyramid | 3600 |
| 11 | 2 | 0.5 | 2 | 0.5 | Truncated pyramid | 2300 |
| 12 | 2 | 1 | 2 | 1 | Truncated pyramid | 2000 |
| 13 | 2 | 2.5 | 2 | 2.5 | Truncated pyramid | 1600 |
| 14 | 2 | 0.1 | 2 | 0.1 | Shoulder | 6000 |
| 15 | 2 | 0.5 | 2 | 0.1 | Shoulder | 4500 |
| 16 | 2 | 0.5 | 2 | 0.5 | Shoulder | 3600 |
| 17 | 2 | 1 | 2 | 1 | Shoulder | 2500 |
| 18 | 2 | 2.5 | 2 | 2.5 | Shoulder | 1800 |

As will be understood from Tables 2 and 3, each of the test samples numbered 9 through 12 and 14 through 17 in which the heat dissipating member has a truncated pyramid shape or is formed with a shoulder portion and the distance a and the distance b as specified previously were adjusted to fall in the ranges defined by the expressions: $0 \le a \le (L_2 - L_1)/2$ and $0 \le b \le (W_2 - W_1)/2$, respectively, gains an advantage over the test samples No. 13 and No. 18 in which the distances a and b fall outside their respective ranges, in terms of the number of cycles counted at the time when cracking was observed for the first time. It will thus be seen that the test samples numbered 9 through 12 and 14 through 17 are higher in heat dissipation characteristics than the test samples No. 13 and No. 18.

**Claims**

1. A heat dissipating board (1) comprising:

    a ceramic substrate (2);
    a metal layer (22) disposed on a surface of the ceramic substrate (2); and
    at least one heat dissipating member (42) having a first surface (A) which is brought into contact with the metal layer (22), and a second surface (A') located on an opposite side of the first surface (A),
    an area of the metal layer (22) being larger than an area of the first surface (A) but being smaller than an area of the second surface (A'),
    **characterized by**
    a space (62) which communicates with outside air located between the heat transmitting member (22) and the heat dissipating member (42).

2. The heat dissipating board (1) of claim 1, wherein the ceramic substrate (2) primarily comprises silicon nitride.

3. The heat dissipating board (1) of claim 1, wherein the metal layer (22) includes an active metal layer (32) and a bonding layer (52) primarily comprising copper, and
    the active metal layer (32) is disposed on the ceramic substrate (2), and the bonding layer (52) is disposed on the active metal layer (32).

4. The heat dissipating board (1) of claim 1, wherein the heat dissipating member (42) primarily comprises copper or an alloy of copper.

5. The heat dissipating board (1) of claim 1, wherein the heat dissipating member (42) is so shaped as to have a longitudinal side and a transverse side in a plan view hereof, and
the length of the longitudinal side is increased stepwise or gradually from the surface A toward the surface A'.

6. The heat dissipating board (1) of claim 1, wherein the heat dissipating member (42) takes on a truncated pyramid shape (1).

7. The heat dissipating board (101) of claim 1, wherein there are provided a plurality of the heat dissipating members (42) arranged in the form of a matrix consisting of a plurality of rows and a plurality of columns.

8. The heat dissipating board (1) of claim 3, wherein the bonding layer (52) is so shaped as to have a longitudinal side in a see-through plan view thereof, and
a distance a between a longitudinal center of a surface B of the bonding layer (52) and a longitudinal center of the surface A of the heat dissipating member (42) is adjusted to fall in a range defined by the following expression:

$$0 \leq a \leq (L_2 - L_1)/2$$

where $L_1$ represents the longitudinal length of the surface A of the heat dissipating member (42) and $L_2$ represents the longitudinal length of the surface B of the bonding layer (52).

9. The heat dissipating board (1) of claim 3, wherein a distance b between a transverse center of the surface B of the bonding layer (52) and a transverse center of the surface A of the heat dissipating member (42) is adjusted to fall in a range defined by the following expression:

$$0 \leq b \leq (W_2 - W_1)/2$$

where $W_1$ represents the transverse length of the surface A of the heat dissipating member (42) and $W_2$ represents the transverse length of the surface B of the bonding layer (52).

10. An electronic apparatus comprising the heat dissipating board (1) of claim 1 and an electronic component (41) mounted on the heat dissipating board (1).

**Patentansprüche**

1. Eine Wärmeabführplatte (1) aufweisend:

    ein Keramiksubstrat (2);
    eine Metallschicht (22), welche auf einer Fläche des Keramiksubstrats (2) angeordnet ist; und
    mindestens ein Wärmeabführelement (42), welches eine erste Fläche (A), die mit der Metallschicht (22) in Kontakt gebracht ist, und eine zweite Fläche (A') aufweist, die auf einer der ersten Fläche (A) gegenüberliegenden Seite angeordnet ist,
    wobei ein Bereich der Metallschicht (22), größer ist als ein Bereich der ersten Fläche (A) aber kleiner ist als ein Bereich der zweiten Fläche (A'),
    **gekennzeichnet durch**
    einen Raum (62), welcher mit Außenluft kommuniziert und zwischen dem Wärmeübertragungselement (22) und dem Wärmeabführelement (42) angeordnet ist.

2. Die Wärmeabführplatte (1) gemäß Anspruch 1, wobei das Keramiksubstrat (2) vorwiegend Siliziumnitrid aufweist.

3. Die Wärmeabführplatte (1) gemäß Anspruch 1, wobei die Metallschicht (22) eine Aktivmetallschicht (32) und eine Bindeschicht (52) aufweist, die vorwiegend Kupfer aufweist, und
wobei die Aktivmetallschicht (32) auf dem Keramiksubstrat (2) angeordnet ist und die Bindeschicht (52) auf der Aktivmetallschicht (32) angeordnet ist.

4. Die Wärmeabführplatte (1) gemäß Anspruch 1, wobei das Wärmeabführelement (42) vorwiegend Kupfer oder eine Kupferlegierung aufweist.

5. Die Wärmeabführplatte (1) gemäß Anspruch 1, wobei das Wärmeabführelement (42) so geformt ist, dass es in einer Draufsicht eine Längsseite und eine Querseite aufweist, und
wobei die Länge der Längsseite von der Fläche A hin zu der Fläche A' schrittweise oder graduell zunimmt.

6. Die Wärmeabführplatte (1) gemäß Anspruch 1, wobei das Wärmeabführelement (42) eine Pyramidenstumpf-Form (1) annimmt.

7. Die Wärmeabführplatte (101) gemäß Anspruch 1, wobei eine Mehrzahl der Wärmeabführelemente (42) bereitgestellt ist, welche in Form einer Matrix angeordnet sind, die aus einer Mehrzahl von Reihen und einer Mehrzahl von Spalten besteht.

8. Die Wärmeabführplatte (1) gemäß Anspruch 3, wobei die Bindeschicht (52) so geformt ist, dass sie in einer transparenten Draufsicht eine Längsseite aufweist, und
wobei ein Abstand a zwischen einer Längsmitte einer Fläche B der Bindeschicht (52) und einer Längsmitte der Fläche A des Wärmeabführelements (42) so angepasst ist, dass er in einen Bereich fällt, der durch den Ausdruck

$$0 \leq a \leq (L_2 - L_1) / 2$$

definiert ist,
wobei $L_1$ die Längslänge der Fläche A des Wärmeabführelements (42) repräsentiert und $L_2$ die Längslänge der Fläche B der Bindeschicht (52) repräsentiert.

9. Die Wärmeabführplatte (1) gemäß Anspruch 3, wobei ein Abstand b zwischen einer Quermitte der Fläche B der Bindeschicht (52) und einer Quermitte der Fläche A des Wärmeabführelements (42) so angepasst ist, dass er in einen Bereich fällt, der durch den Ausdruck

$$0 \leq b \leq (W_2 - W_1) / 2$$

definiert ist,
wobei $W_1$ die Querlänge der Fläche A des Wärmeabführelements (42) repräsentiert und $W_2$ die Querlänge der Fläche B der Bindeschicht (52) repräsentiert.

10. Eine elektronische Vorrichtung aufweisend die Wärmeabführplatte (1) gemäß Anspruch 1 und eine elektronische Komponente (41), welche an der Wärmeabführplatte (1) angebracht ist.

**Revendications**

1. Carte de dissipation de chaleur (1) comprenant :

- un substrat céramique (2) ;
- une couche métallique (22) disposée sur une surface du substrat céramique (2) ; et
- au moins un élément dissipateur de chaleur (42) possédant une première surface (A) mise en contact avec la couche métallique (22), et une seconde surface (A') située sur le côté opposé à la première surface (A) ;
- une étendue de la couche métallique (22) étant plus grande qu'une étendue de la première surface (A) mais plus petite qu'une étendue de la seconde surface (A') ;
- **caractérisé par** :
- un espace (62) qui communique avec l'air extérieur situé entre l'élément transmetteur de chaleur (22) et l'élément dissipateur de chaleur (42).

2. Carte de dissipation de chaleur (1) selon la revendication 1, dans laquelle le substrat céramique (2) comprend essentiellement du nitrure de silicium.

3. Carte de dissipation de chaleur (1) selon la revendication 1, dans laquelle la couche métallique (22) comprend une couche métallique active (32) et une couche de liaison (52) comprenant essentiellement du cuivre ; et

    - la couche métallique active (32) est disposée sur le substrat céramique (2) tandis que la couche de liaison (52) est disposée sur la couche métallique active (32).

4. Carte de dissipation de chaleur (1) selon la revendication 1, dans laquelle l'élément dissipateur de chaleur (42) comprend essentiellement du cuivre ou un alliage de cuivre.

5. Carte de dissipation de chaleur (1) selon la revendication 1, dans laquelle l'élément dissipateur de chaleur (42) est mis en forme de manière à présenter un côté longitudinal et un côté transversal lorsque vu en plan ; et

    - la longueur du côté longitudinal augmente par degrés ou graduellement depuis la surface A vers la surface A'.

6. Carte de dissipation de chaleur (1) selon la revendication 1, dans laquelle l'élément dissipateur de chaleur (42) a la forme d'une pyramide tronquée (1).

7. Carte de dissipation de chaleur (101) selon la revendication 1, dans laquelle on utilise plusieurs éléments dissipateurs de chaleur (42) disposés en forme de matrice consistant en plusieurs rangées et plusieurs colonnes.

8. Carte de dissipation de chaleur (1) selon la revendication 3, dans laquelle la couche de liaison (52) est mise en forme de manière à présenter un côté longitudinal dans une vue en plan transparente de celle-ci ; et

    - une distance a entre un centre longitudinal d'une surface B de la couche de liaison (52) et un centre longitudinal de la surface A de l'élément dissipateur de chaleur (42) est ajustée pour se situer dans une plage correspondant à l'expression suivante :

$$0 \leq a \leq (L_2 - L_1) / 2$$

    - où $L_1$ représente la longueur longitudinale de la surface A de l'élément dissipateur de chaleur (42), et $L_2$ représente la longueur longitudinale de la surface B de la couche de liaison (52).

9. Carte de dissipation de chaleur (1) selon la revendication 3, dans laquelle une distance b entre un centre transversal de la surface B de la couche de liaison (52) et un centre transversal de la surface A de l'élément dissipateur de chaleur (42) est ajustée pour se situer dans une plage correspondant à l'expression suivante :

$$0 \leq b \leq (W_2 - W_1) / 2$$

    - où $W_1$ représente la longueur transversale de la surface A de l'élément dissipateur de chaleur (42), et $W_2$ représente la longueur transversale de la surface B de la couche de liaison (52).

10. Appareil électronique comprenant la carte de dissipation de chaleur (1) selon la revendication 1, et un composant électronique (41) monté sur la carte de dissipation de chaleur (1).

# FIG. 1

(a)

(b)

(c)

# FIG. 2

# FIG. 3

( a )

( b )

*FIG. 4*

A

A'    42

*FIG. 5*

A

A'    42

*FIG. 6*

( a )

A

42

( b )

A

A'

42

*FIG. 7*

( a )

( b )

( c )

# FIG. 8

(a)

101

102a
141
151

R

(b)

141
151
131

102a

$H_1$

132
152
142

(c)

102b
141
151

R

(d)

141
151
131

102b

$H_2$

132
152
142

# FIG. 9

( a )

122

142

( b )

$L_1$

$L_2$

0'

$a$

0

$b$

$W_1$

$W_2$

## FIG. 10

( a )

122

142

( b )

$L_1$  $L_2$

O

$W_1$

$W_2$

# F I G. 11

152

142

# FIG. 12

( a )

( b )

( c )

# FIG. 13

( a )

101

102
141
151

XⅢB
XⅢB

( b )

141
151
131
102
132
152
142

( c )

A'
A
B

102
152
142

# FIG. 14

( a )

( b )

( c )

# FIG. 15

( a )

101

102
141
151

X
Y

XVB · · · · · · · XVB

( b )

141
151
131
102
132
152
142

( c )

B  A  A'  B  A  A'  B  A

A'

A'

B  A  A'  B  A  A'  B  A

102

142
152

30

# FIG. 16

( a )

( b )

( c )

( d )

**EP 2 109 138 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1107310 A2
- JP 9069590 A
- JP 2006245437 A